# EUROPEAN PATENT SPECIFICATION

(11) **EP 2 990 502 B1**
(45) Date of publication and mention of the grant of the patent: **25.10.2017**
(21) Application number: 15182407.5
(22) Date of filing: 25.08.2015
(51) Int. Cl.: C23C 14/56, C23C 14/58, C23C 14/54

(54) **VACUUM COATERS AND METHODS OF OPERATING A VACUUM COATER**
VAKUUMBESCHICHTUNGSVORRICHTUNGEN UND VERFAHREN ZUM BETRIEB EINER VAKUUMBESCHICHTUNGSVORRICHTUNG
MACHINES À ENDUIRE SOUS VIDE ET PROCÉDÉS D'EXPLOITATION DE TELLES MACHINES

(30) Priority: 27.08.2014 GB 201415169
(43) Date of publication of application: 02.03.2016
(73) Proprietor: Bobst Manchester Limited, Heywood, Lancashire OL10 2TL (GB)
(72) Inventor: COPELAND, Nicholas John, Cheshire SK15 2TX (GB); GILPIN, Richard John, Ramsbottom BL0 9TS (GB)
(74) Representative: Leadbetter, Benedict

(56) References cited:
- EP-A1- 1 400 990
- EP-A1- 2 530 183
- JP-A- 2008 138 290

## Description

### Field of the Invention

The invention relates to vacuum coaters and methods of operating a vacuum coater for coating a polymeric web with a metal or metal oxide.

### Background to the Invention

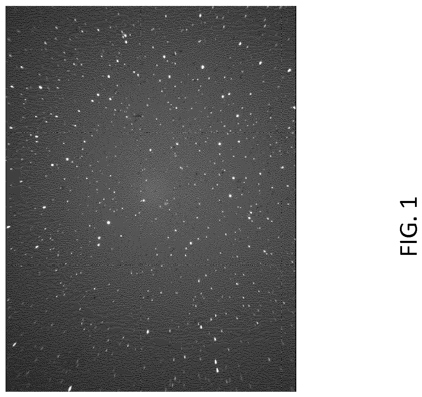

Figure 1 shows an image of a typical prior art metal coated polymeric web under the microscope. In this particular view, there are almost a hundred pin holes greater than 10 microns in an area of 3mm². The defect sizes vary generally from 10 to 30 microns in this example. The polymeric web employed for this microscopic assessment is of polyethylene terephthalate (PET). The oxygen transmission rates (OTR) are on average approximately 1 cc/m²/day and the water vapour transmission rate (WVTR) is approximately 1 g/m²/day for a 2.3 to 2.8 OD on 12 micron standard commodity grade polyethylene terephthalate (PET).

The potential objects of embodiments of the invention are:
- Optical improvements (higher opacity per coating thickness);
- More homogeneous conformal coating thin films;
- Significant defects reduction (even potentially to micro-size level);
- Improved barrier performance;
- Improved layer separation;
- Reduction in blocking potential particularly for certain heat sensitive substrates; and
- Accelerated oxidation of a metal coating.

EP 1 400 990 A shows a vacuum coater for manufacturing a metallized film in which oxidizing gas is sprayed onto the surface of the coated film as it is wound up.

### Summary of the Invention

In its broadest independent aspect the invention provides, a vacuum coater according to claim 1 for coating a polymeric web with metal or metal oxide comprising an unwind, a deposition and a rewind portion; wherein the coater further comprises a gas injector in the rewind portion for providing a gas to or about the metallised web prior to rewinding the web onto the rewind roller. This configuration is particularly advantageous since it reduces defects, improves barrier properties, improves the temperature management and reduces associated blocking and metal pickoff. In a preferred and advantageous configuration the gas is cold or cooled in order to further cool the metallised web. In a preferred aspect, the injector is positioned to provide a gas immediately prior to rewinding the web onto the rewind roller. Furthermore, in certain embodiments it provides increased cooling, layer separation and accelerated oxidation of the element surface which results in a significant reduction in the so called "starry night" type defects in the film as seen in Figure 1, an improved associated barrier performance and a reduction in blocking potential on more heat sensitive or thinner gauge substrates. This configuration allows for additional "dwell" time when the film is subjected to cooled input gas significantly reducing the rewind roll temperature and resolving a significant problem which the industry has suffered with particularly when processing heat sensitive substrates or when processing films with low sealing temperature or down gauged/thinner substrates. In preferred embodiments, the exposure time to a cooled medium is at least the vent time of the machine up to the processing time of the roll typically 60 minutes which is normally several minutes as opposed to typical times of 0.1 seconds or less. This configuration will also in certain embodiments improve the processing of film in high temperature environments whilst at the same time enabling longer storage periods and potentially preventing blocking during post conversion.

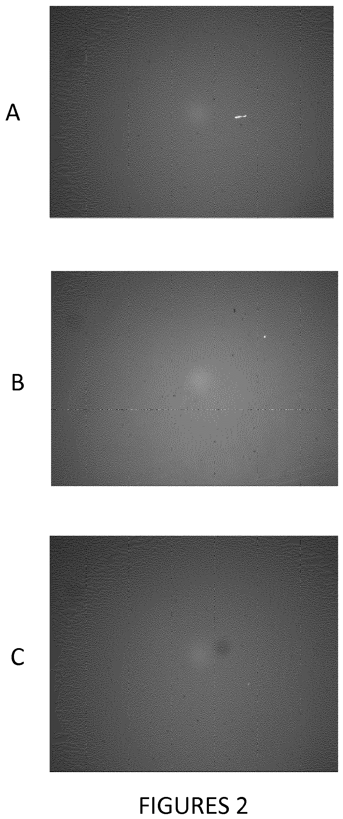

In a subsidiary aspect, the coater supports the web after the deposition portion solely on the non-coated polymeric surface of the metallised or metal oxide coated web. Synergistically when providing the injection of cold gas after a non-contact web path instead of the "starry" night results of Figure 1, any defects in the web are difficult to find as shown in the embodiments of Figures 2a, b and c.

In a further subsidiary aspect, the gas injector injects ionised gas in the vicinity of the web to passivate the web. This configuration further improves the properties of the resulting web and prevents static build up in the web.

In a further subsidiary aspect, the coater incorporates a rewind roller as part of the rewind portion and a gas injector injects between the metallised web surface and the rewind roller. When injecting cooled gas at that particular location, the metallised coating is advantageously cooled whilst providing a degree of air cushioning between layers of wrapped around web.

In a further subsidiary aspect, the gas injector is wedge-shaped in cross-section and the gas exits the injector through an aperture located at the narrowing extremity of the wedge. This configuration is particularly advantageous in terms of increasing the velocity of the gas exiting the injector. It also allows the gas to be appropriately directed and provided between layers of wrapped around web for maximum effective cooling of the roll.

In a further subsidiary aspect, the gas injector is a bar spanning the width of the web and is displaceable to accommodate the increasing diameter of the rewind roll. This configuration allows the advantageous positioning of the gas injector relative to the variable roller diameter during the rewinding process.

In a further subsidiary aspect, the coater incorporates a plurality of gas injectors located in a sequence along the path followed by the web. This configuration allows the gas treatment to be progressive and therefore to achieve improved web treatment prior to the rewinding of the web.

In a further subsidiary aspect, at least one of the gas injectors injects ionised gas in the vicinity of the web to passivate the web and at least one other of the gas injectors injects cold gas to cool the web. This configuration is particularly advantageous in combining passivation and cooling of the web to optimise the achievable barrier properties.

In a further subsidiary aspect, the coater further comprises a plasma source located along the web path after the deposition portion and before the gas injector. This configuration is particularly advantageous in terms of further improving the achievable barrier properties.

In a further independent aspect, the invention provides a method according to claim 9 of operating a vacuum coater for coating a polymeric web with metal or metal oxide comprising the step of providing cold gas to or about the metallised web prior to rewinding the web onto the rewind roller.

In a subsidiary aspect, the method further comprises the step of supporting the web after deposition solely on the polymeric surface of the metallised or metal oxide coated web.

In a subsidiary aspect, the method further comprises the step of injecting ionised gas in the vicinity of the web to passivate the web.

In a further subsidiary aspect, the method comprises the steps of providing a coater with a rewind roller and a web with a metallised web surface; and injecting gas between the metallised web surface and the rewind roller.

In a subsidiary aspect, the method further comprises the step of providing a gas injector which is wedge-shaped in cross-section and which has an aperture located at the narrowing extremity of the wedge to allow the gas to exit the wedge.

In a further subsidiary aspect, the method further comprises the steps of providing a gas injector in the form of a bar spanning the width of the web and displacing the bar to accommodate the increase diameter of the rewind roll.

In a further subsidiary aspect, the method further comprises the step of providing a plurality of gas injectors located in a sequence along the path followed by the web.

In a further subsidiary aspect, the method further comprises the steps of passivating the web and injecting cold gas.

In a further subsidiary aspect, the method comprises the further step of providing a plasma source located along the web path after the deposition portion and before the gas injector.

### Brief Description of the Figures

Figure 1 shows an area of metallised web as seen under the microscope which was produced according to prior art techniques.
Figure 2a, b and c show areas of metallised web as seen under the microscope which was produced according to embodiments of the invention.
Figure 3 shows a schematic side elevation of a coater in accordance with an embodiment of the invention.
Figure 4 shows a schematic side view of the rewind portion with a gas injector in accordance with an embodiment of the invention.
Figure 5 shows a schematic perspective view of the rewind portion with a gas injector in accordance with an embodiment of the invention.
Figures 6 show areas of metallised web as seen under the microscope which were produced according to a prior art embodiment (figure 6 a)) and various embodiments of the invention (figures 6 b) and 6 c)).

### Detailed Description of the Figures

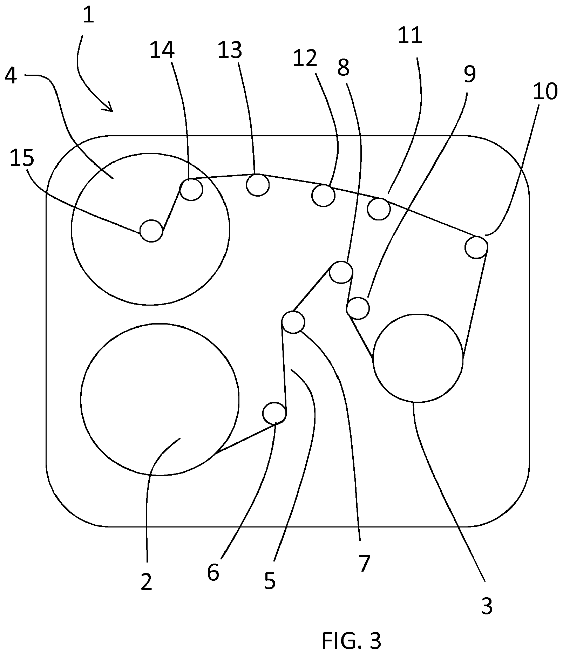

Figure 3 shows a coater generally referenced 1 with an unwind portion 2. A deposition portion 3 and a rewind portion 4. In the embodiment of coater 1, a pre-plasma treater 5 is provided in addition to pre-deposition rollers 6, 7, 8 and 9. A number of post-deposition rollers are provided such as rollers 10, 11, 12, 13 and 14. In a preferred embodiment the metallised surface of the web exiting the deposition portion does not engage any of the post-deposition rollers. In other words, the web path post-deposition is a non-contact web path. Only the polymeric surface of the coated web engages rollers 10 to 14 before being wound onto rewind roller 15.

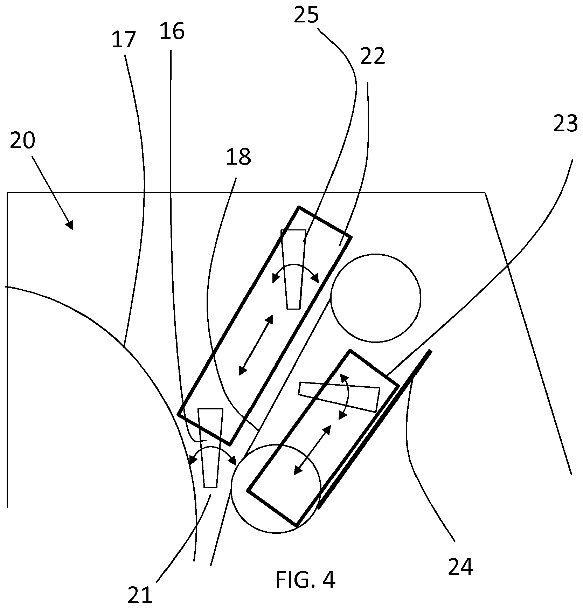

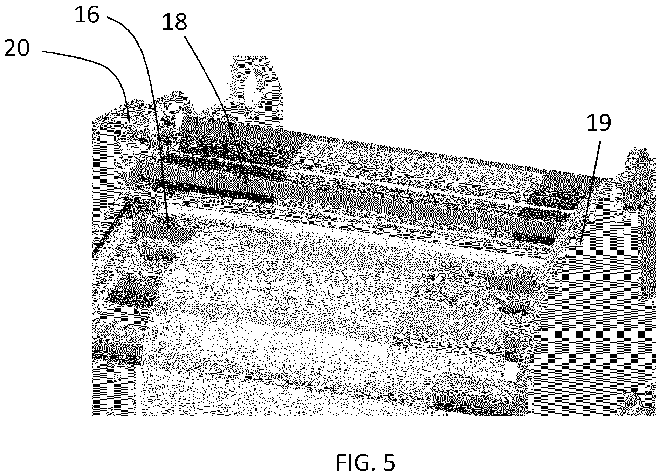

Figure 4 shows an embodiment of the invention where an adjustable cold gas injector 16 is placed between the rewind roll 17 and the coated web 18. As can be seen on Figure 5, the injector 16 spans the width of the coater between side plates 19 and 20. The gas injector 16 takes the form of a wedge when viewed in cross-section as shown in Figure 4. The gas injector may incorporate a manifold spanning the width of the injector. Additionally, a plasma source can be included, located along the web path after the deposition portion and before the gas injector 16. A number of gas conduits may be provided to inject cold gas into the manifold prior to exiting the forward most tip 21 of the gas injector. The gas injector is secured onto a mount 22 which itself may be secured onto a carriage 23. Carriage 23 is configured to displace relative to the plate 20 on appropriately configured guides or rails 24. The displacement of the carriage 23 ensures the appropriate positioning of the gas injector relative to the roll and web. A sensor may be provided to detect the diameter of the roll in real time as the web is wound around the rewind roller. In addition to the gas injector 16, a second gas injector 25 is secured to the mount 22 in a rearward position thus allowing the gas injector 25 to treat the web prior to the treatment provided between the web and the roll. In addition to injecting cold gas, the gas may provide ionisation to discharge electric charge built up on the film. The discharge of the built up charge would also have a particularly beneficial safety advantage over simply cooling the coated web. This configuration also allows oxidation of the aluminium to provide a protective layer and potentially improve barrier whilst reducing pick off. Each one of the injectors may be configured to pivot or displace in order to allow the injection of medium to be directed to various portions of the web. Optionally, the injectors may be driven to displace as appropriate to direct medium over a wider area. Injectors 16 and 25 are located on the metallised side of the web. Optionally, one or more further injectors may be provided on the underside of the web and directed towards the non-coated side of the web. Optionally, the or each injector is provided solely on the coated side of the web.

The following section contrasts various measured barrier properties for a conventional prior art contact web path and various embodiments of the invention.

**Table 1 shows data for a conventional contact web path**

| Oxygen transmission rates (OTR) (cc/m².day) (50%RH 23 C) | | | | Water vapour transmission rates (WVTR) (g/gm².day) (90% RH 37.8 C) | | | |
|---|---|---|---|---|---|---|---|
| Cell A | Cell B | OTR Average | (+/-) | Cell A | Cell B | WVTR Average | (+/-) |
| 0.820 | 0.940 | 0.88 | 0.08 | 0.810 | 0.960 | 0.89 | 0.11 |

**Table 2 which are the results of an embodiment of the invention employing a rewind gas wedge at 2SLM with chilled air. Figure 2 a) shows the corresponding view of the produced metallised web as seen under the microscope.**

| Oxygen transmission rates (OTR) (cc/m².day) (50%RH 23 C) | | | | | Water vapour transmission rates (WVTR) (g/gm².day) (90% RH 37.8 C) | | | |
|---|---|---|---|---|---|---|---|---|
| OD and coating | Cell A | Cell B | OTR Average | (+/-) | Cell A | Cell B | WVTR Average | (+/-) |
| 2.25 | 0.23 | 0.27 | 0.253 | 0.029 | 0.16 | 0.20 | 0.183 | 0.025 |

**Table 3 is an embodiment of the invention where 7kW pre-treatment has been employed with 85% O2/15% Ar. Figure 2 b) shows the corresponding view of the produced metallised web as seen under the microscope. Figure 2 c) shows a view of a corresponding 7 kW pre-treatment with the rewind gas wedge on, an anti-static bar on, and a gas wedge on.**

| Oxygen transmission rates (OTR) (cc/m².day) (50%RH 23 C) | | | | | Water vapour transmission rates (WVTR) (g/gm².day) (90% RH 37.8 C) | | | |
|---|---|---|---|---|---|---|---|---|
| OD and coating | Cell A | Cell B | OTR Average | (+/-) | Cell A | Cell B | WVTR Average | (+/-) |
| 2.35 | 0.18 | 0.25 | 0.221 | 0.048 | 0.29 | 0.33 | 0.315 | 0.031 |

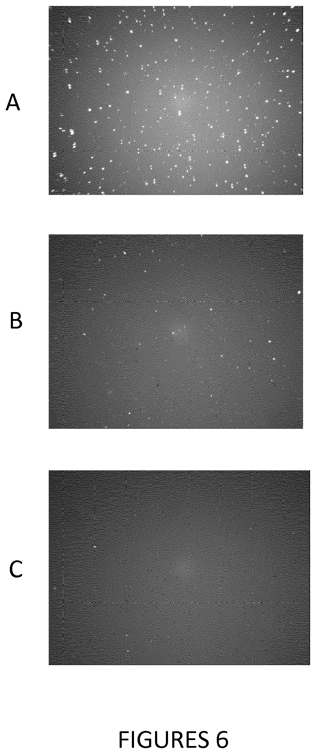

Figures 6 show the results for embodiments of the invention for oriented polypropylene (OPP). In figure 6 a) the prior art film was produced using a contact web path and the rewind roll temperature was approx. 24 to 26 degrees C. A number of pin holes and defects can be seen throughout. In figure 6 b) the film was produced with a gas wedge in the rewind area and with a non-contact web path post-deposition. A temperature reduction was experienced at the rewind roll to less than 20 degrees Celsius. As can be seen a dramatic reduction of the number of defects has been experienced. In figure 6 c) a non-contact web path was employed with a rewind gas wedge and a pre-plasma treater. Virtually no defects are visible whilst the rewind roll temperature was reduced to approx. 20 degrees Celsius.

At least one or more of the following improvements may be achieved in embodiments of the invention:
- Barrier improvement; dyne level retention over time
- Aluminium layer protection via accelerated oxidation
- Ability to process much more heat sensitive substrates (gauge/thickness reduction, high-surface roughness films, low sealing temperature surfaces/back surfaces)
- Ability to run process drum at higher temperatures

## Claims

1. A vacuum coater (1) for coating a polymeric web with metal or metal oxide comprising an unwind (2), a deposition (3) and a rewind (4) portion; said rewind portion (4) comprising a rewind roller (17) for forming a rewind roll; **characterised in that** said coater (1) further comprises a gas injector (16) which is spaced from said web (16) and which is located in the narrowing space defined between the rewind roll's outer diameter and the coated web in order to provide a cooling gas between the rewind roll's outer diameter and the coated web as the web is drawn onto the rewind roll.

2. A vacuum coater according to claim 1, wherein said coater supports said web after the deposition portion solely on the polymeric surface of the metallised or metal oxide coated web.

3. A vacuum coater according to either claim 1 or claim 2, wherein said gas injector injects ionised gas in the vicinity of said web to passivate said web.

4. A vacuum coater according to any of the preceding claims, wherein said gas injector is wedge-shaped in cross-section and the gas exits the injector through an aperture located at the narrowing extremity of the wedge.

5. A vacuum coater according to any of the preceding claims, wherein said gas injector is a bar spanning the width of the web and is displaceable to accommodate the increasing diameter of the rewind roll.

6. A vacuum coater according to any of the preceding claims, wherein said coater incorporates a plurality of gas injectors located in a sequence along the path followed by the web.

7. A vacuum coater according to claim 6, wherein at least one of said gas injectors injects ionised gas in the vicinity of the web to passivate the web and at least one other of said gas injectors injects cooling gas to cool said web.

8. A vacuum coater according to any of the preceding claims, wherein said coater further comprises a plasma source located along the web path after the deposition portion and before the gas injector.

9. A method of operating a vacuum coater for coating a polymeric web with metal or metal oxide; the coater being provided with an unwind, a deposition, and rewind portion with rewind roller for forming a rewind roll comprising the steps of providing a gas injector which is spaced from said web and which is located in the narrowing space defined between the rewind roll's outer diameter and the coated web; and injecting a cooling gas between said rewind roll's outer diameter and the coated web as the web is drawn onto the rewind roll.

10. A method according to claim 9, comprising the step of supporting said web after deposition solely on the polymeric surface of the metallised or metal oxide coated web.

11. A method according to either claim 9 or claim 10, further comprising the step of injecting ionised gas in the vicinity of said web to passivate said web.

12. A method according to any of claims 9 to 11, further comprising the step of providing a gas injector which is wedge-shaped in cross-section and which has an aperture located at the narrowing extremity of the wedge to allow the gas to exit the wedge.

13. A method according to any of claims 9 to 12, further comprising the steps of providing a gas injector in the form of a bar spanning the width of the web and displacing said bar to accommodate the increasing diameter of the rewind roll.

14. A method according to any of claims 9 to 13, further comprising the step of providing a plurality of gas injectors located in a sequence along the path followed by the web, and preferably further comprising the steps of passivating the web and injecting cooling gas.

15. A method according to any of claims 9 to 14, comprising the further step of providing a plasma source located along the web path after the deposition portion and before the gas injector.

## Patentansprüche

1. Vakuumbeschichtungsvorrichtung (1) zum Beschichten eines Polymergewebes mit Metall oder Metalloxid, umfassend einen Abwicklungs- (2), einen Auftragungs- (3) und einen Aufwicklungsabschnitt (4); wobei der Aufwicklungsabschnitt (4) einen Aufwicklungsroller (17) zum Bilden einer Aufwicklungswalze umfasst; **dadurch gekennzeichnet, dass** die Beschichtungsvorrichtung (1) weiter einen Gasinjektor (16) umfasst, der vom Gewebe (16) beabstandet ist und in dem verjüngenden Raum angeordnet ist, der zwischen dem Außendurchmesser der Aufwicklungswalze und dem beschichteten Gewebe definiert ist, um ein Kühlgas zwischen dem Außendurchmesser der Aufwicklungswalze und dem beschichteten Gewebe bereitzustellen, während das Gewebe auf die Aufwicklungswalze gezogen wird.

2. Vakuumbeschichtungsvorrichtung nach Anspruch 1, wobei die Beschichtungsvorrichtung das Gewebe nach dem Auftragungsabschnitt nur auf der Polymerfläche des metallisierten oder mit Metalloxid beschichteten Gewebes stützt.

3. Vakuumbeschichtungsvorrichtung nach Anspruch 1 oder Anspruch 2, wobei der Gasinjektor ionisiertes Gas in der Umgebung des Gewebes injiziert, um das Gewebe zu passivieren.

4. Vakuumbeschichtungsvorrichtung nach einem der vorstehenden Ansprüche, wobei der Gasinjektor einen keilförmigen Querschnitt hat und das Gas den Injektor durch eine Öffnung verlässt, die am verjüngenden Endpunkt des Keils angeordnet ist.

5. Vakuumbeschichtungsvorrichtung nach einem der vorstehenden Ansprüche, wobei der Gasinjektor ein Balken ist, der sich über die Breite des Gewebes erstreckt und verschiebbar ist, um den größer werdenden Durchmesser der Aufwicklungswalze aufzunehmen.

6. Vakuumbeschichtungsvorrichtung nach einem der vorstehenden Ansprüche, wobei die Beschichtungsvorrichtung eine Mehrzahl von Gasinjektoren beinhaltet, die in einer Reihe entlang des Wegs angeordnet sind, dem das Gewebe folgt.

7. Vakuumbeschichtungsvorrichtung nach Anspruch 6, wobei mindestens einer der Gasinjektoren ionisiertes Gas in der Umgebung des Gewebes injiziert, um das Gewebe zu passivieren, und mindestens ein anderer der Gasinjektoren Kühlgas injiziert, um das Gewebe zu kühlen.

8. Vakuumbeschichtungsvorrichtung nach einem der vorstehenden Ansprüche, wobei die Beschichtungsvorrichtung weiter eine Plasmaquelle umfasst, die entlang des Gewebewegs nach dem Auftragungsabschnitt und vor dem Gasinjektor angeordnet ist.

9. Verfahren zum Betreiben einer Vakuumbeschichtungsvorrichtung zum Beschichten eines Polymergewebes mit Metall oder Metalloxid; wobei die Beschichtungsvorrichtung mit einem Abwicklungs-, einem Auftragungs- und einem Aufwicklungsabschnitt mit einem Aufwicklungsroller zum Bilden einer Aufwicklungswalze versehen ist, umfassend die Schritte des Bereitstellens eines Gasinjektors, der vom Gewebe beabstandet ist und in dem verjüngenden Raum angeordnet ist, der zwischen dem Außendurchmesser der Aufwicklungswalze und dem beschichteten Gewebe definiert ist; und des Injizierens eines Kühlgases zwischen dem Außendurchmesser der Aufwicklungswalze und dem beschichteten Gewebe, während das Gewebe auf die Aufwicklungswalze gezogen wird.

10. Verfahren nach Anspruch 9, umfassend den Schritt des Stützens des Gewebes nach der Auftragung nur auf der Polymerfläche des metallisierten oder mit Metalloxid beschichteten Gewebes.

11. Verfahren nach Anspruch 9 oder Anspruch 10, weiter umfassend den Schritt des Injizierens ionisierten Gases in der Umgebung des Gewebes, um das Gewebe zu passivieren.

12. Verfahren nach einem der Ansprüche 9 bis 11, weiter umfassend den Schritt des Bereitstellens eines Gasinjektors, der einen keilförmigen Querschnitt und eine Öffnung hat, die am verjüngenden Endpunkt des Keils angeordnet ist, sodass das Gas den Keil verlassen kann.

13. Verfahren nach einem der Ansprüche 9 bis 12, weiter umfassend die Schritte des Bereitstellen eines Gasinjektors in der Form eines Balkens, der sich über die Breite des Gewebes erstreckt, und des Verschiebens des Balkens, um den größer werdenden Durchmesser der Aufwicklungswalze aufzunehmen.

14. Verfahren nach einem der Ansprüche 9 bis 13, weiter umfassend den Schritt des Bereitstellens einer Mehrzahl von Gasinjektoren, die in einer Reihe entlang des Wegs angeordnet sind, dem das Gewebe folgt, und vorzugsweise weiter umfassend die Schritte des Passivierens des Gewebes und des Injizierens von Kühlgas.

15. Verfahren nach einem der Ansprüche 9 bis 14, umfassend den weiteren Schritt des Bereitstellens einer Plasmaquelle, die entlang des Gewebewegs nach dem Auftragungsabschnitt und vor dem Gasinjektor angeordnet ist.

## Revendications

1. Machine à enduire sous vide (1) pour le revêtement d'une bande polymère avec un métal ou un oxyde métallique comprenant une portion de déroulement (2), de dépôt (3) et de rembobinage (4) ; ladite portion de rembobinage (4) comprenant un rouleau de rembobinage (17) pour former un cylindre de rembobinage ; **caractérisé en ce que** ladite machine à enduire (1) comprend en outre un injecteur de gaz (16) qui est espacé de ladite bande (16) et qui est situé dans l'espace se rétrécissant défini entre le diamètre extérieur de cylindre de rembobinage et la bande revêtue afin de fournir un gaz de refroidissement entre le diamètre extérieur de cylindre de rembobinage et la bande revêtue lorsque la bande est tirée sur le cylindre de rembobinage.

2. Machine à enduire sous vide selon la revendication 1, dans laquelle ladite machine à enduire supporte ladite bande après la portion de dépôt seulement sur la surface polymère de la bande métallisée ou revêtue d'oxyde métallique.

3. Machine à enduire sous vide selon la revendication 1 ou la revendication 2, dans laquelle ledit injecteur de gaz injecte du gaz ionisé au voisinage de ladite bande pour passiver ladite bande.

4. Machine à enduire sous vide selon l'une quelconque des revendications précédentes, dans lequel ledit injecteur de gaz a une section transversale en forme de coin et le gaz sort de l'injecteur à travers une ouverture située au niveau de l'extrémité se rétrécissant du coin.

5. Machine à enduire sous vide selon l'une quelconque des revendications précédentes, dans lequel ledit injecteur de gaz est une barre enjambant la largeur du tissu et qui peut être déplacée pour loger le diamètre croissant du cylindre de rembobinage.

6. Machine à enduire sous vide selon l'une quelconque des revendications précédentes, dans laquelle ladite machine à enduire incorpore une pluralité d'injecteurs de gaz situés dans une séquence le long du chemin suivi par la bande.

7. Machine à enduire sous vide selon la revendication 6, dans laquelle au moins un desdits injecteurs de gaz injecte du gaz ionisé au voisinage de la bande pour passiver la bande et au moins un autre desdits injecteurs de gaz injecte un gaz de refroidissement pour refroidir ladite bande.

8. Machine à enduire sous vide selon l'une quelconque des revendications précédentes, dans laquelle ladite machine à enduire comprend en outre une source de plasma située le long du chemin de bande après la portion de dépôt et avant l'injecteur de gaz.

9. Procédé de mise en oeuvre d'une machine à enduire sous vide pour le revêtement d'une bande polymère avec un métal ou un oxyde métallique ; la machine à enduire étant munie d'une portion de déroulement, de dépôt et de rembobinage avec un rouleau de rembobinage pour former un cylindre de rembobinage comprenant les étapes de fourniture d'un injecteur de gaz qui est espacé de ladite bande et qui est situé dans l'espace se rétrécissant défini entre le diamètre extérieur de cylindre de rembobinage et la bande revêtue ; et d'injection d'un gaz de refroidissement entre ledit diamètre extérieur de cylindre de rembobinage et la bande revêtue lorsque la bande est tirée sur le cylindre de rembobinage.

10. Procédé selon la revendication 9, comprenant l'étape de support de ladite bande après le dépôt seulement sur la surface polymère de la bande métallisée ou revêtue d'oxyde métallique.

11. Procédé selon la revendication 9 ou la revendication 10, comprenant en outre l'étape d'injection de gaz ionisé au voisinage de ladite bande pour passiver ladite bande.

12. Procédé selon l'une quelconque des revendications 9 à 11, comprenant en outre l'étape de fourniture d'un injecteur de gaz qui a une section transversale en forme de coin et qui a une ouverture située au niveau de l'extrémité se rétrécissant du coin pour permettre au gaz de sortir du coin.

13. Procédé selon l'une quelconque des revendications 9 à 12, comprenant en outre les étapes de fourniture d'un injecteur de gaz sous la forme d'une barre enjambant la largeur de la bande et de déplacement de ladite barre pour loger le diamètre croissant du cylindre de rembobinage.

14. Procédé selon l'une quelconque des revendications 9 à 13, comprenant en outre l'étape de fourniture d'une pluralité d'injecteurs de gaz situés dans une séquence le long du chemin suivi par la bande, et de préférence comprenant en outre les étapes de passivation de la bande et d'injection de gaz de refroidissement.

15. Procédé selon l'une quelconque des revendications 9 à 14, comprenant l'étape supplémentaire consistant à fournir une source de plasma située le long du chemin de bande après la portion de dépôt et avant l'injecteur de gaz.
